# EUROPÄISCHE PATENTSCHRIFT

(11) **EP 0 929 990 B1**
(45) Veröffentlichungstag und Bekanntmachung des Hinweises auf die Patenterteilung: **26.04.2006**
(21) Anmeldenummer: 98943675.3
(22) Anmeldetag: 13.07.1998
(51) Int. Cl.: H05B 3/14

(54) **ELEKTRISCHE HEIZUNG FÜR EIN KRAFTFAHRZEUG**
ELECTRIC HEATER FOR A MOTOR VEHICLE
CHAUFFAGE ELECTRIQUE POUR UN VEHICULE A MOTEUR

(30) Priorität: 31.07.1997 DE 19733045
(43) Veröffentlichungstag der Anmeldung: 21.07.1999
(73) Patentinhaber: Robert Bosch GmbH, 70839 Gerlingen-Schillerhöhe (DE)
(72) Erfinder: EINSENHARDT, Harald, D-71277 Rutesheim (DE); FALLIANO, Rolf, D-73635 Steinenberg (DE)
(74) Vertreter: Müller, Georg
(86) Internationale Anmeldenummer: PCT/DE1998/001948
(87) Internationale Veröffentlichungsnummer: WO 1999/007185

(56) Entgegenhaltungen:
- EP-A- 0 134 985
- EP-A- 0 564 027
- DE-A- 3 442 350

## Beschreibung

### Stand der Technik

Die Erfindung betrifft eine elektrische Heizung für ein Kraftfahrzeug, bei der als Wärmequelle die von Leistungshalbleitern erzeugte Wärme verwendet ist.

Eine derartige Heizung ist aus der DE 34 42 350 C2 bekannt. Bei dieser bekannten elektrische Heizung steuert der Leistungshalbleiter den elektrischen Antriebsmotor. Der Leistungshalbleiter ist mit einem von Kühlflüssigkeit durchflossenen Kühlkörper verbunden, so daß die erzeugte Wärme im Wärmetauschverfahren auf die Kühlflüssigkeit übertragen wird. Die Kühlflüssigkeit zirkuliert in einem geschlossenen Leitungssystem, das eine Pumpe und die eigentliche Heizungsanlage aufweist.

Der Wirkungsgrad dieser bekannten elektrischen Heizung ist nicht besonders hoch, da die von dem Leistungshalbleiter erzeugte Wärme mehrfach umgesetzt wird. Außerdem ist der Aufbau der Heizungsanlage aufwendig, von dem anfallenden Motorstrom abhängig und damit auch nicht unabhängig von diesem regelbar.

### Vorteile der Erfindung

Es ist Aufgabe der Erfindung, eine elektrische Heizung der eingangs erwähnten Art zu schaffen, bei der mit einfachem Aubau der Wirkungsgrad wesentlich erhöht ist, eine unabhängige Regelung der Heizleistung möglich ist.

Diese Aufgabe wird nach der Erfindung nach einer ersten Ausgestaltung dadurch gelöst, daß zur Wärmeerzeugung mehrere Stromzweige mit jeweils einem im Hochleistungsveriustbetrieb betriebenen Leistungshalbleiter parallelgeschaltet sind, oder nach einer zweiten Ausgestaltung dadurch, daß zur Wärmeerzeugung mehrere Stromzweige mit jeweils zwei in Reihe geschalteten und im Hochleistungsverlustbetrieb betriebenen Leistungshalbleitern parallelgeschaltet sind.

Bei diesen Ausgestaltungen wird der Strom durch die Leistungshalbleiter direkt in Wärme umgesetzt, was den Wirkungsgrad wesentlich erhöht. Ein weiterer Vorteil der neuen Heizung liegt darin, daß kein zusätzliches Ansteuermodul für die Heizung benötigt wird. Der Einbau der Heizung in das Kraftfahrzeug ist auch wesentlich vereinfacht. Hinzukommt, daß auch der Verkabelungsaufwand und die Herstellkosten für die neue elektrische Heizung reduziert sind.

Eine besondere Absicherung der Heizung am Bordnetz kann entfallen. Bei der Inbetriebnahme der Heizung kann der hohe Einschaltstromstoß durch sanftes geregeltes Ansteigen des Stromes vermieden werden. Das neue Heizmodul kann zur Erhöhung der Heizleistung beliebig kaskadiert und auch einfach in einen Gebläseregler integriert werden.

Zum Schutz der Leistungshalbleiter ist nach einer Ausgestaltung vorgesehen, daß in jedem Stromzweig ein auf Überlast ansprechendes Schaltglied mit dem Leistungshalbleiter in Reihe geschaltet ist. Mit dem Schaltglied kan im Fehlerfall der betroffene Stromzweig abgeschaltet werden, ohne die Funktion der Heizung als Ganzes aufgeben zu müssen. Die Heizleistung wird lediglich im Verhältnis von den defekten Stromzweigen zu allen Stromzweigen reduziert.

Die Regelung der Heizleistung wird nach einer Ausgestaltung einfach dadurch ermöglicht, daß die Leistungshalbleiter mittels eines gemeinsam vorgebbaren Sollwertes und mittels von den Leistungshalbleitern abgeleiteten Istwerten in der abgegebenen Leistung individuell regelbar sind, oder daß die jeweils einen Leistungshalbleiter der Stromzweige mittels eines gemeinsamen vorgebbaren Sollwertes und mittels an diesen Leistungshalbleitern abgeleiteten Istwerten und die jeweils anderen Leistungshalbleiter mittels einer fest vorgegebenen Steuerspannung und mittels an diesen Leistungshalbleitern abgeleiteten Istwerten in ihren Leistungen individuell regelbar sind.

Ist vorgesehen, daß die Stromzweige ausgangsseitig einen niederohmigen Vorwiderstand als Lastwiderstand speisen, dann kann die von dem Vorwiderstand erzeugte Wärme zur Erhöhung der Heizleistung beitragen. Dabei kann jeder Leistungshalbleiter einen individuellen Vorwiderstand speisen. Alle Leistungshalbleiter können auch einen gemeinsamen Vorwiderstand speisen oder es können Gruppen von Leistungshalbleitern jeweils mit einem gruppenindividuellen Vorwiderstand verbunden sein.

Die Schaltglieder zur Unterbrechung der Stromzweige können auf unterschiedliche Weise realisiert werden. So kann nach einer Ausgestaltung vorgesehen sein, daß die Schaltglieder als Leiterbahnstück der Stromzweige ausgebildet sind, die bei Fehlerfall im zugeordneten Stromzweig auftretendem, erhöhtem Strom durchbrennen. Dieselbe Wirkung läßt sich auch dadurch erreichen, daß die Schaltglieder als Strommeßwiderstand in die Stromzweige eingeschleift sind, die bei Fehlerfall im zugeordneten Stromzweig auftretenden erhöhten Strom durchbrennen, wobei der Strommeßwiderstand zusätzlich zur Ableitung eines weiteren Steuersignals verwendet werden kann. Schließlich läßt sich der Stromzweig auch dadurch unterbrechen, daß als Schaltglied die Anschlußdrähte der Leistungshalbleiter verwendet sind, die bei Fehlerfall im zugeordneten Stromzweig auftretendem, erhöhtem Strom durchbrennen.

Eine gesteuerte Reduzierung oder Unterbrechung des Stromes in einem defekten Stromzweig ergibt sich dann, wenn vorgesehen ist, daß bei Kurzschluß eines der beiden, in einem Stromzweig in Reihe geschalteten Leistungshalbleiters aus dem defekten Stromzweig ein zusätzliches Steuersignal ableitbar ist, das den jeweils anderen Leistungshalbleiter in der abgegebenen Leistung reduziert oder in den Ausschaltzustand steuert. Als Steuersignal kann dabei auch das am Strommeßwiderstand abgegriffene Steuersignal verwendet werden.

Der konstruktive Aufbau der neuen elektrischen Heizung kann dadurch noch vereinfacht werden, daß sie als Heizmodul aufgebaut ist, wobei die Leistungshalbleiter in thermischem Kontakt auf einem Kühlkörper befestigt sind, wobei die Wärmeabgabe über den Kühlkörper verbessert wird.

Eine einfache Temperaturüberwachung läßt sich dadurch bei der elektrischen Heizung erreichen, daß die Leistungshalbleiter und/oder der Kühlkörper mittels Temperaturfühler auf das Überschreiten einer vorgegebenen Maximaltemperatur überwacht sind, und daß die Ausgangssignale der Temperaturfühler oder des Temperaturfühlers die zugeordneten Leistungshalbleiter oder alle Leistungshalbleiter in der abgegebenen Leistung reduzieren oder in den Ausschaltzustand steuern. Werden die Leistungshalbleiter mittels individueller Temperaturfühler überwacht, dann wird der Aufwand dafür dadurch reduziert, daß die Temperaturfühler in die Leistungshalbleiter integriert sind.

Die Erfindung wird anhand von in den Zeichnungen dargestellten Ausführungen näher erläutert Es zeigen:
- Fig. 1: als Stromlaufplan eine elektrische Heizung mit n parallelgeschalteten Stromzweigen, die jeweils einen Leistungshalbleiter enthalten, und
- Fig. 2: als Stromlaufplan eine elektrische Heizung mit n parallelgeschalteten Stromzweigen, die jeweils zwei in Reihe geschaltete Leistungshalbleiter aufweisen.

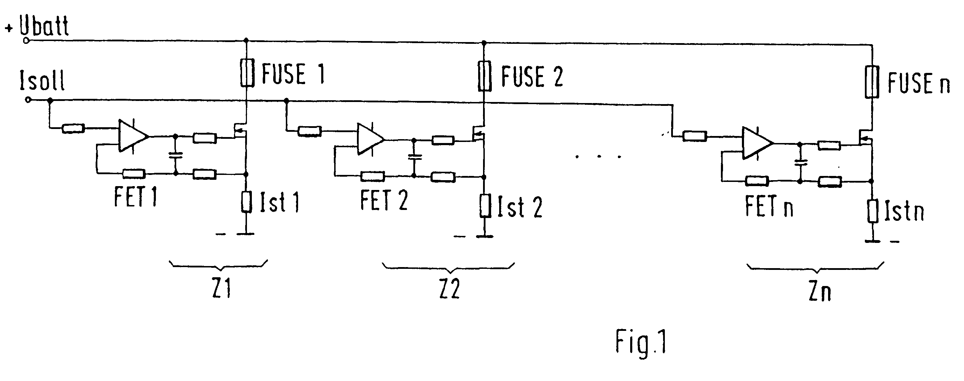

Wie die Fig. 1 zeigt, sind an der Versorgungsspannung Ubatt die Stromzweige Z1, Z2 ... Zn parallel zueinander angeschaltet, wobei jeder Stromzweig Z1, Z2 .. Zn einen Leistungshalbleiter FET1, FET2 ... FETn aufweist. Die Anschaltung an die Versorgungsspannung Ubatt erfolgt über Schaltglieder FUSE1, FUSE2 ... FUSEn, die im Fehlerfall, z.B. Kurzschluß des Leistungshalbleiters, bei dem dabei auftretenden, mehrfachen Strom eine individuelle Unterbrechung des Stromzweiges Z1, Z2 ... Zn vornehmen. In die Anschaltung der Leistungshalbleiter FET1, FET2 ... FETn an das Massepotential kann ein nicht näher bezeichneter Strommeßwiderstand eingeschaltet sein, an dem ein für den Stromzweig Z1, Z2 ... Zn individueller Istwert Ist1, Ist2 ... Istn ableitbar ist. Dem Gate-Anschluß der Leistungshalbleiter FET,1 FET2 ... FETn wird über einen als Reglerschaltung dienenden Komparator oder Operationsverstärker neben dem am Strommeßwiderstand abgegriffenen Istwert ein Sollwert Isoll zugeführt, um die Leistung im zugeordneten Leistungshalbleiter kontinuierlich regeln zu können. Übersteigt der Istwert den Sollwert Isoll, dann steuert die Reglerschaltung den Leistungshalbleiter in den Ausschaltzustand oder regelt diesen in der abgegebenen Leistung zurück. Außerdem kann das Schaltglied FUSE1, FUSE2 .. FUSEn beim Kurzschluß des zugeordneten Leistungshalbleiters FET1, FET2 ... FETn den Stromzweig Z1, Z2 ... Zn vollständig unterbrechen.

Als Schaltglieder FUSE1, FUSE2 ... FUSEn können Leiterbahnstücke des Stromzweiges Z1, Z2 ... Zn selbst verwendet werden. Je nach Auslegung der Stromzweige Z1, Z2 ... Zn und der zugeordneten Reglerschaltung kann im Kurzschlußfall der Strom auf den 25- bis 50-fachen Wert ansteigen, so daß das Leiterbahnstück durchbrennt. Auch der Strommeßwiderstand kann als Schaltglied verwendet werden, wenn dieser bei diesem Stromanstieg durchbrennt und den Stromzweig Z1, Z2 ... Zn unterbricht. Selbst die Anschlußdrähte der Leistungshalbleiter FET1, FET2 ... FETn können so dimensioniert sein, daß sie die Funktion der Schaltglieder FUSE1, FUSE2 ... FUSEn übernehmen. Die elektrische Heizung dieser Art kann als Heizmodul aufgebaut, auf einem Kühlkörper befestigt und in einen Gebläseregler integriert werden, wobei hinzukommt, daß das Heizmodul selbst zum Bordnetz des Kraftfahrzeuges hin nicht mehr abgesichert werden muß. Es kann jedoch erforderlich sein, die Zuleitungen zum Heizmodul abzusichern.

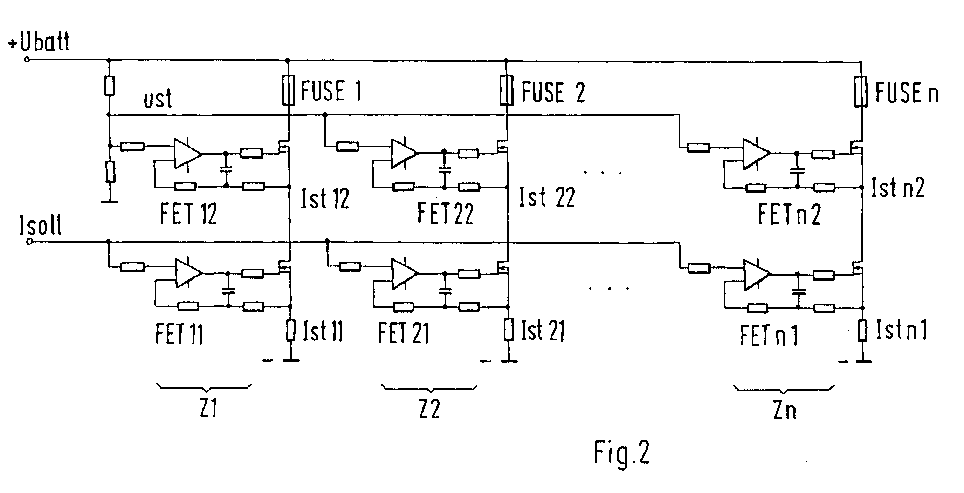

Bei dem Ausführungsbeispiel nach Fig. 2 weist jeder Stromzweig Z1, Z2 ... Zn zwei in Reihe geschaltete Leistungshalbleiter FET11 und FET12, FET21 und FET22 ... FETn1 und FETn2 auf, die jeweils über eine eigene Reglerschaltung angesteuert werden. Wie beim Ausführungsbeispiel nach Fig. 1 kann in die Stromzweige Z1, Z2 ... Zn ein Schaltglied FUSE1, FUSE2 ... FUSEn sowie ein Strommeßwiderstand eingeschleift sein. Die Schaltglieder FUSE1, FUSE2 ... FUSEn sind wieder in den beschriebenen Varianten auslegbar. An den Strommeßwiderständen der Stromzweige Z1, Z2 ... Zn sind Steuersignale abgreifbar, die den Istwert Ist11, Ist21 .. Istn1 des Stromzweiges kennzeichnen und den Regelschaltungen der zugeordneten einen Leistungshalbleiter FET11, FET21 ... FETn1 zugeführt werden, denen zusätzlich ein Sollwert Isoll zuführbar ist, um die Leistung im Stromzweig Z1, Z2 ... Zn zu regeln. Die anderen Leistungshalbleiter FET12, FET22 ... FETn2 werden von getrennten Regelschaltungen gesteuert, denen eine fest vorgegebene Steuerspannung ust und ein Istwert Ist12, Ist22 .. Istn2 zugeführt wird, der aus dem Spannungsabfall am vorgeschalteten einen Leistungshalbleiter FET11, FET21 ... FETn1 abgeleitet wird. Beim Kurzschluß oder Defekt eines Leistungshaibleiters, z.B. FET11 kann bei dieser Auslegung der Reglerschaltungen der jeweils andere Leistungshalbleiter, z.B. FET12, im Stromzweig Z1 abgeschaltet oder in der abgegebenen Leistung reduziert werden. Das Restsystem bleibt in seiner Funktion jedoch erhalten, lediglich die Heizleistung wird im Verhältnis der defekten Stromzweige zu allen Stromzweigen reduziert.

Werden beide Leistungshalbleiter, z.B. FET21 und FET22, kurzgeschlossen, dann tritt das Schaltglied, z.B. FUSE2, wie beim Ausführungsbeispiel nach Fig. 1, in Funktion und unterbricht bei dem auftretenden hohen Stromanstieg den Stromzweig, z.B. Z2.

Wird zur Erhöhung der Heizleistung nur ein gemeinsamer wärmeabgebender, niederohmiger Vorwiderstand als Lastwiderstand für alle Stromzweige Z1, Z2 ... Zn verwendet, dann ist dieser in die gemeinsame, zur Batteriespannung Ubatt führende Leitung eingeschleift. Dieser Vorwiderstand ändert die Arbeitsweise der elektrischen Heizung nicht, es wird lediglich der Stromanstieg im Kurzschlußfall des einzigen Leistungshalbleiters (Fig. 1) oder beider Leistungshalbleiter (Fig. 2) auf einen niedrigeren Wert begrenzt, der jedoch zum sicheren Ansprechen des Schalt-gliedes FUSE1, FUSE2 ... FUSEn noch ausreicht. Die vom Vorwiderstand erzeug-te Wärme wird ebenfalls zur Heizung mit verwendet, bringt aber eine Leistungs-aufteilung mit sich, die bei einer vorgegebenen maximalen Heizleistung zu einer Erweiterung des Temperatureinsatzbereiches für die Heizung ausgenützt werden kann.

Jeder Leistungshalbleiter oder jedes Leistungshalbleiterpaar kann auch über einen individuellen Vorwiderstand an der Batteriespannung Ubatt angeschaltet sein. Es können auch Gruppen von Stromzweigen einen Vorwiderstand speisen. In jedem Fall sind alle Vorwiderstände an der Erzeugung von Wärme beteiligt.

In die neue Heizung läßt sich auf einfache Weise eine Temperaturüberwachung einbauen. So kann jedem Leistungshalbleiter ein Temperaturfühler zugeordnet sein, der auch in den Leistungshalbleiter integriert sein kann. Wird eine vorgegebene Maximaltemperatur am Leistungshalbleiter überschritten, dann steuert das Ausgangssignal des Temperaturfühlers den zugeordneten Leistungshalbleiter so, daß er in seiner abgegebenen Leistung reduziert oder vollständig abgeschaltet wird.

Es kann auch nur ein einziger Temperaturfühler vorgesehen sein, mit dem die Temperatur des Kühlkörpers gemessen wird, mit dem alle Leistungshalbleiter der elektrischen Heizung in thermischem Kontakt stehen. Übersteigt die Temperatur des Kühlkörpers eine vorgegebene Maximaltemperatur, dann werden alle Leistungshalbleiter mit dem Ausgangssignal des Temperaturfühlers so gesteuert, daß ihre abgegebenen Leistungen reduziert sind oder daß sie voll abgeschaltet sind. Dazu können auch unterschiedliche Werte des Ausgangssignals des Temperaturfühlers verwendet werden, wobei zunächst beim ersten niedrigeren Wert das Ausgangssignal eine Leistungsreduzierung und beim zweiten höheren Wert des Ausgangssignals die Vollabschaltung vollzogen wird.

## Patentansprüche

1. Elektrische Heizung für ein Kraftfahrzeug, bei der als Wärmequelle die von Leistungshalbleitern erzeugte Wärme verwendet ist,
**dadurch gekennzeichnet,**
**daß** zur Wärmeerzeugung mehrere Stromzweige (Z1, Z2, Zn) mit jeweils einem im Hochleistungsverlustbetrieb betriebenen Leistungshalbleiter (FET1, FET2, FETn) parallelgeschaltet sind.

2. Elektrische Heizung für ein Kraftfahrzeug, bei der als Wärmequelle die von Leistungshalbleitern erzeugte Wärme verwendet ist,
**dadurch gekennzeichnet,**
**daß** zur Wärmeerzeugung mehrere Stromzweige (Z1, Z2, Zn) mit jeweils zwei in Reihe geschalteten und im Hochleistungsverlustbetrieb betriebenen Leistungshalbleitern (FET11, FET12; FET21, FET22; FETn1, FETn2) parallelgeschaltet sind.

3. Elektrische Heizung nach Anspruch 1 oder 2,
**dadurch gekennzeichnet,**
**daß** in jedem Stromzweig (Z1, Z2, Zn) ein auf Überlast ansprechendes Schaltglied (FUSE1, FUSE2, FUSEn) mit dem Leistungshalbleiter (FET1, FET2, FETn) in Reihe geschaltet ist.

4. Elektrische Heizung nach Anspruch 1 oder 3,
**dadurch gekennzeichnet,**
**daß** die Leistungshalbleiter (FET1, FET2, FETn) mittels eines gemeinsam vorgebbaren Sollwertes (Isoll) und mittels von den Leistungshalbleitern (FET1, FET2 ... FETn) abgeleiteten Istwerten (Ist1. Ist2 ... Istn) in der abgegebenen Leistung individuell regelbar sind.

5. Elektrische Heizung nach Anspruch 2 oder 3,
**dadurch gekennzeichnet,**
**daß** die jeweils einen Leistungshalbleiter (FET11, FET21, FETn1) der Stromzweige (Z1, Z2, Zn) mittels eines gemeinsamen vorgebbaren Sollwertes (Isoll) und mittels an diesen Leistungshalbleitern abgeleiteten Istwerten (Ist11, Ist21 ... Istn1) und die jeweils anderen Leistungshalbleiter (FET12, FET22 ... FETn2) mittels einer fest vorgegebenen Steuerspannung (ust) und mittels an diesen Leistungshalbleitern abgeleiteten Istwerten (Ist12, Ist2 ... Istn2) in ihren Leistungen individuell regelbar sind.

6. Elektrische Heizung nach einem der Ansprüche 1 bis 5,
**dadurch gekennzeichnet,**
**daß** die Leistungshalbleiter (FET1, FET2 ... FETn; FET11, FET12, FET21, FET22 .. FETn1, FETn2) im Kurzschluß betrieben sind.

7. Elektrische Heizung nach einem der Ansprüche 1 bis 6,
**dadurch gekennzeichnet,**
**daß** die Stromzweige (Z1, Z2 ... Zn) ausgangsseitig einen niederohmigen Vorwiderstand als Lastwiderstand speisen.

8. Elektrische Heizung nach einem der Ansprüche 1 bis 7,
**dadurch gekennzeichnet,**
**daß** die Schaltglieder (FUSE1, FUSE2 ... FUSEn) als Leiterbahnstück der Stromzweige (Z1, Z2 ... Zn) ausgebildet sind, die bei Fehlerfall im zugeordneten Stromzweig (Z1, Z2 ... Zn) auftretendem, erhöhtem Strom durchbrennen.

9. Elektrische Heizung nach einem der Ansprüche 1 bis 7,
**dadurch gekennzeichnet,**
**daß** die Schaltglieder (FUSE1, FUSE2, FUSEn) als Strommeßvviderstand in die Stromzweige (Z1, Z2, Zn) eingeschleift sind, die bei Fehlerfall im zugeordneten Stromzweig (Z1, Z2 ... Zn) auftretendem erhöhtem Strom durchbrennen.

10. Elektrische Heizung nach einem der Ansprüche 1 bis 7,
**dadurch gekennzeichnet,**
**daß** als Schaltglied (FUSE1, FUSE2, FUSEn) die Anschlußdrähte der Leistungshalbleiter (FET1, FET2, FETn; FET11, FET12, FET21, FET22, FETn1, FETn2) verwendet sind, die bei Fehlerfall im zugeordneten Stromzweig (Z1, Z2, Zn) auftetendem, erhöhtem Strom durchbrennen.

11. Elektrische Heizung nach einem der Ansprüche 2, 3 und 5 bis 7,
**dadurch gekennzeichnet,**
**daß** bei Kurzschluß eines der beiden, in einem Stromzweig (Z1, Z2, Zn) in Reihe geschalteten Leistungshalbleiters (FET1 oder FET12; FET21 oder FET22; FETn1 oder FETn2) aus dem defekten Stromzweig (Z1, Z2, Zn) ein zusätzliches Steuersignal ableitbar ist, das den jeweils anderen Leistungshalbleiter (FET12 oder FET11; FET22 oder FET21; FETn2 oder FETn1) in der abgegebenen Leistung reduziert oder in den Ausschaltzustand steuert.

12. Elektrische Heizung nach einem der Ansprüche 1 bis 11,
**dadurch gekennzeichnet,**
**daß** sie als Heizmodul aufgebaut ist, wobei die Leistungshalbleiter (FET1, FET2 ... FETn; FET11, FET12; FET21, FET22; FETn1, FETn2) in thermischem Kontakt auf einem Kühlkörper befestigt sind.

13. Elektrische Heizung nach Anspruch 12,
**dadurch gekennzeichnet,**
**daß** die Leistungshalbleiter (FET1, FET2 ... FETn; FET11, FET12, FET21, FET22 ... FETn1, FETn2) und/oder der Kühlkörper mittels Temperaturfühler auf das Überschreiten einer vorgegebenen Maximaltemperatur überwacht sind, und
**daß** die Ausgangssignale der Temperaturfühler oder des Temperaturfühlers die zugeordneten Leistungshalbleiter oder alle Leistungshalbleiter in der abgegebenen Leistung reduzieren oder in den Ausschaltzustand steuern.

14. Elektrische Heizung nach Anspruch 13,
**dadurch gekennzeichnet,**
**daß** die Temperaturfühler in die Leistungshalbleiter (FET1, FET2 ... FETn; FET11, FET12, FET21, FET22 ... FETn1, FETn2) integriert sind.

## Claims

1. Electrical heater for a motor vehicle, in which the heat generated by power semiconductors is used as the heat source,
**characterized**
**in that** a plurality of current paths (Z1, Z2, Zn), which each have a power semiconductor (FET1, FET2, FETn) which is operated in the high-power loss mode, are connected in parallel in order to generate heat.

2. Electrical heater for a motor vehicle, in which the heat generated by power semiconductors is used as the heat source,
**characterized**
**in that** a plurality of current paths (Z1, Z2, Zn), which each have two power semiconductors (FET11, FET12; FET21, FET22; FETn1, FETn2) which are connected in series and operated in the high-power loss mode, are connected in parallel in order to generate heat.

3. Electrical heater according to Claim 1 or 2,
**characterized**
**in that** a switching element (FUSE1, FUSE2, FUSEn) which responds to an overload is connected in series with the power semiconductor (FET1, FET2, FETn) in each current path (Z1, Z2, Zn) .

4. Electrical heater according to Claim 1 or 3,
**characterized**
**in that** the power output by the power semiconductors (FET1, FET2, FETn) can be individually controlled by means of a common prescribable setpoint value (Iset) and by means of actual values (Act1, Act2 ... Actn) which are derived from the power semiconductors (FET1, FET2 ... FETn).

5. Electrical heater according to Claim 2 or 3,
**characterized**
**in that** the power of one respective power semiconductor (FET11, FET21, FETn1) of the current paths (Z1, Z2, Zn) can be individually controlled by means of a common prescribable setpoint value (Iset) and by means of actual values (Act11, Act21 ... Actn1) which are derived at these power semiconductors, and the powers of the other respective power semiconductors (FET12, FET22 ... FETn2) can be individually controlled by means of a definitively prescribed control voltage (ust) and by means of actual values (Act12, Act22 ... Actn2) which are derived at these power semiconductors.

6. Electrical heater according to one of Claims 1 to 5,
**characterized**
**in that** the power semiconductors (FET1, FET2 ... FETn; FET11, FET12, FET21, FET22 ... FETn1, FETn2) are operated short-circuited.

7. Electrical heater according to one of Claims 1 to 6,
**characterized**
**in that** the outputs of the current paths (Z1, Z2 ... Zn) feed a low-impedance series resistor as the load resistor.

8. Electrical heater according to one of Claims 1 to 7,
**characterized**
**in that** the switching elements (FUSE1, FUSE2 ... FUSEn) are in the form of conductor track pieces of the current paths (Z1, Z2 ... Zn) and blow when an increased current occurs in the event of a fault in the associated current path (Z1, Z2 ... Zn).

9. Electrical heater according to one of Claims 1 to 7,
**characterized**
**in that** the switching elements (FUSE1, FUSE2, FUSEn) are looped into the current paths (Z1, Z2, Zn) as current-measuring resistors and blow when an increased current occurs in the event of a fault in the associated current path (Z1, Z2 ... Zn).

10. Electrical heater according to one of Claims 1 to 7,
**characterized**
**in that** the switching elements (FUSE1, FUSE2, FUSEn) used are the connection wires of the power semiconductors (FET1, FET2, FETn; FET11, FET12, FET21, FET22, FETn1, FETn2) which blow when an increased current occurs in the event of a fault in the associated current path (Z1, Z2, Zn).

11. Electrical heater according to one of Claims 2, 3 and 5 to 7,
**characterized**
**in that**, in the event of a short circuit in one of the two power semiconductors (FET11 or FET12; FET21 or FET22; FETn1 or FETn2) which are connected in series in a current path (Z1, Z2, Zn), an additional control signal can be derived from the defective current path (Z1, Z2, Zn) and reduces the power output by the other respective power semiconductor (FET12 or FET11; FET22 or FET21; FETn2 or FETn1) or controls the switch-off state of the said power semiconductor.

12. Electrical heater according to one of Claims 1 to 11,
**characterized**
**in that** the said heater is designed as a heating module, with the power semiconductors (FET1, FET2 ... FETn; FET11, FET12; FET21, FET22; FETn1, FETn2) being fixed to a heat sink such that they are in thermal contact.

13. Electrical heater according to Claim 12,
**characterized**
**in that** the power semiconductors (FET1, FET2 ... FETn; FET11, FET12, FET21, FET22 ... FETn1, FETn2) and/or the heat sink are monitored by means of temperature sensors to check whether they exceed a prescribed maximum temperature, and
**in that** the output signals of the temperature sensors or of the temperature sensor reduce the power output by the associated power semiconductors or all of the power semiconductors or control the switch-off state of the said power semiconductors.

14. Electrical heater according to Claim 13,
**characterized**
**in that** the temperature sensors are integrated in the power semiconductors (FET1, FET2 ... FETn; FET11, FET12, FET21, FET22 ... FETn1, FETn2).

## Revendications

1. Chauffage électrique pour un véhicule à moteur, dans lequel on utilise la chaleur produite par des semi-conducteurs de puissance comme source de chaleur,
**caractérisé en ce que**
pour produire de la chaleur, plusieurs branches de circuit (Z1, Z2, Zn) sont chacune branchées en parallèle à un semi-conducteur de puissance commandé en mode de dissipation de haute puissance (FET1, FET2, FETn).

2. Chauffage électrique pour un véhicule à moteur, dans lequel on utilise la chaleur produite par des semi-conducteurs de puissance comme source de chaleur,
**caractérisé en ce que**
pour produire de la chaleur, plusieurs branches de circuit (Z1, Z2, Zn) sont chacune branchées en parallèle à deux semi-conducteurs de puissance branchés en série et commandés en mode de dissipation de haute puissance (FET11, FET12; FET21, FET22; FETn1, FETn2).

3. Chauffage électrique selon la revendication 1 ou 2,
**caractérisé en ce que**
dans chaque branche de circuit (Z1, Z2, Zn), un élément de contact (FUSE1, FUSE2, FUSEn) réagissant à une surcharge est branché en série au semi-conducteur de puissance (FET1, FET2, FETn).

4. Chauffage électrique selon la revendication 1 ou 3,
**caractérisé en ce qu'**
on peut régler individuellement la puissance produite par les semi-conducteurs de puissance (FET1, FET2, FETn) au moyen d'une valeur de consigne prédéfinie commune (Iso11), et au moyen de valeurs réelles (Istl1 Ist2 ... Istn) dérivées des semi-conducteurs de puissance (FET1, FET2 ... FETn).

5. Chauffage électrique selon la revendication 2 ou 3,
**caractérisé en ce qu'**
on peut régler individuellement la puissance pour chacun des premiers semi-conducteurs de puissance (FET11, FET21, FETn1) des branches de circuit (Z1, Z2, Zn) au moyen d'une valeur de consigne prédéfinie commune (Isoll) et au moyen de valeurs réelles (Ist11, Ist21... Istn1) dérivées de ces semi-conducteurs de puissance, et pour chacun des autres semi-conducteurs de puissance (FET12, FET22, FETn2) au moyen d'une tension de commande prédéfinie de manière fixe (ust) et au moyen de valeurs réelles (Ist12, Ist22 ... Istn2) dérivées de ces semi-conducteurs de puissance.

6. Chauffage électrique selon l'une quelconque des revendications 1 à 5,
**caractérisé en ce que**
les semi-conducteurs de puissance (FET1, FET2 ... FETn ; FET11, FET12, FET21, FET22 .. FETn1, FETn2) fonctionnent en court-circuit.

7. Chauffage électrique selon l'une quelconque des revendications 1 à 6,
**caractérisé en ce que**
les branches de circuit (Z1, Z2 .. Zn) alimentent du côté sortie une résistance série de basse impédance comme résistance de charge.

8. Chauffage électrique selon l'une quelconque des revendications 1 à 7,
**caractérisé en ce que**
les éléments de contact (FUSE1, FUSE2 ... FUSEn) sont constitués comme des tronçons de pistes conductrices des branches de circuit (Z1, Z2 .. Zn), qui grillent en cas d'incident où une élévation de courant survient dans la branche de circuit concernée (Z1, Z2 .. Zn).

9. Chauffage électrique selon l'une quelconque des revendications 1 à 7,
**caractérisé en ce que**
les éléments de contact (FUSE1, FUSE2, FUSEn) sont insérés comme résistances de ballast dans les branches de circuit (Z1, Z2, Zn), et grillent en cas d'incident où une élévation de courant survient dans la branche de circuit concernée (Z1, Z2 ... Zn).

10. Chauffage électrique selon l'une quelconque des revendications 1 à 7,
**caractérisé en ce que**
les fils de connexion des semi-conducteurs de puissance (FET1, FET2, FETn ; FET11, FET12, FET21, FET22, FETn1, FETn2) sont utilisés comme éléments de contact (FUSE1, FUSE2, FUSEn) qui grillent en cas d'incident où une élévation de courant survient dans la branche de circuit concernée (Z1, Z2 .. Zn).

11. Chauffage électrique selon l'une quelconque des revendications 2, 3 et 5 à 7,
**caractérisé en ce qu'**
en cas de court-circuit de l'un des deux semi-conducteurs de puissance (FET11 ou FET12 ; FET21 ou FET22; FETn1 ou FETn2) branchés en série dans une branche de circuit (Z1, Z2, Zn), un signal de commande supplémentaire peut être dérivé de la branche de circuit défectueuse (Z1, Z2, Zn), signal qui réduit la puissance produite de l'autre semi-conducteur de puissance correspondant (FET12 ou FET11; FET22 ou FET21; FETn2 ou FETn1) ou qui le met hors-circuit.

12. Chauffage électrique selon l'une quelconque des revendications 1 à 11,
**caractérisé en ce qu'**
il est construit comme un module de chauffage, dans lequel les semi-conducteurs de puissance (FET1, FET2 ... FETn ; FET11, FET12 ; FET21, FET22 ; FETn1, FETn2) sont fixés en contact thermique contre un dissipateur thermique.

13. Chauffage électrique selon la revendication 12,
**caractérisé en ce que**
les semi-conducteurs de puissance (FET1, FET2 .. FETn: FET11, FET12, FET21, FET22 ... FETn1, FETn2) et/ou le dissipateur thermique sont surveillés au moyen de capteurs de température afin de reconnaître le dépassement d'une température maximale prédéfinie, et
les signaux de sortie des capteurs de température ou du capteur de température réduisent la puissance produite par les semi-conducteurs de puissance concernés ou par tous les semi-conducteurs de puissance, ou les commandent pour les mettre hors circuit.

14. Chauffage électrique selon la revendication 13,
**caractérisé en ce que**
les capteurs de température sont intégrés dans les semi-conducteurs de puissance (FET1, FET2 ... FETn; FET11, FET12, FET21, FET22 .. FETn1, FETn2).
